(19) Europäisches Patentamt
European Patent Office
Office européen des brevets

(11) **EP 2 816 586 A1**

(12) **EUROPEAN PATENT APPLICATION**

(43) Date of publication:
**24.12.2014 Bulletin 2014/52**

(51) Int Cl.:
***H01J 37/32*** *(2006.01)*

(21) Application number: **13172352.0**

(22) Date of filing: **17.06.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Institute of Nuclear Energy Research Atomic Energy Council, Executive Yuan Taoyuan County (TW)**

(72) Inventors:
• **Chen, Hsin-Liang**
  **90442 Pingtung County (TW)**

• **Hsieh, Cheng-Chang**
  **60083 Chiayi City (TW)**
• **Lin, Deng-Lain**
  **Taoyuan County (TW)**
• **Du, Yan-Zheng**
  **TW/Taoyuan County (TW)**
• **Ai, Chi-Fong**
  **32545 Taoyuan County (TW)**
• **Yang, Ming-Chung**
  **Taoyuan County (TW)**

(74) Representative: **Lang, Christian**
  **LangPatent**
  **Anwaltskanzlei IP Law Firm**
  **Rosenheimer Strasse 139**
  **81671 München (DE)**

(54) **Large-area plasma generating apparatus**

(57) A large-area plasma generating apparatus is disclosed, which includes a reaction chamber; a first electrode disposed in the reaction chamber; a second electrode parallel with the first electrode and disposed in the reaction chamber; and a discharge region formed between the first and second electrodes and a plasma can be formed therein; wherein a travelling wave or a traveling-wave-like electromagnetic field is generated via at least one of the first and second electrodes and travels from one end of the discharge region to its opposite end, so as to uniform the plasma in the discharge region.

200

FIG.2A

**Description**

**TECHNICAL FIELD**

The present disclosure relates to the field of large-area plasma generation, and more particularly, to a plasma generating apparatus in which multiple standing waves with specific patterns are launched simultaneously so that their superposition would result in a traveling wave or a traveling-wave-like electromagnetic field. Accordingly, the uniformity of plasma discharge can be effectively improved.

**TECHNICAL BACKGROUND**

Large-area plasma enhanced chemical vapor deposition (PECVD) has been considered as one of the most important apparatus to make the energy costs of thin film silicon solar cells competitive with grid electricity in that it can effectively improve the production throughput and hence reduce the production costs because of the characteristics of larger substrate and higher deposition rate. However, the nonuniform discharge caused by the standing wave effect imposes limitation on achieving uniform thin film deposition in large-area PECVD. Up to date, several attempts have been proposed to resolve the technological bottleneck, including lens-shaped electrode, ladder-shaped electrode or dual comb-type electrodes with phase modulation, superposition of two standing waves that are alternatively ignited and multiple feeding points. Although all the above-mentioned means could more or less improve the uniformity of plasma discharge, most of them might be limited to a fixed frequency and a specific operation window because they are based on the design concept that the configuration of special shaped electrode or the number and arrangement of feeding points is designed for a given standing wave pattern. Nevertheless, for radio-frequency (RF) and very-high-frequency (VHF) plasmas, the standing wave pattern depends on the wavelength of electromagnetic wave in the plasma region, which could be influenced by a variety of experimental parameters, such as frequency, discharge gap, power, pressure, and gas compositions. The actual wavelength in plasma ranges from 12% to 60% of that in vacuum.

Consequently, it is in need to develop a new plasma generating apparatus which is capable of providing large-area uniform plasma in its discharge region.

**TECHNICAL SUMMARY**

According to one aspect of the present disclosure, one embodiment provides a plasma generating apparatus including: a reaction chamber; a first electrode disposed in the reaction chamber; a second electrode parallel with the first electrode and disposed in the reaction chamber; and a discharge region formed between the first and second electrodes and a plasma can be formed therein; wherein a travelling wave or a traveling-wave-like electromagnetic field is generated by launching multiple standing waves with specific patterns at the same time via at least one of the first and second electrodes and travels from one end of the discharge region to its opposite end, so as to uniform the plasma in the discharge region.

In the embodiments, the plasma generating apparatus may further include a first feeding point on one end of the first electrode and a second feeding point on its opposite end; and a third feeding point on one end of the second electrode and a fourth feeding point on its opposite end; wherein two electromagnetic waves with a first phase difference are respectively launched into the first and second feeding points, so as to form a first standing wave in the discharge region; and wherein two electromagnetic waves with a second phase difference are respectively launched into the third and fourth feeding points, so as to form a second standing wave in the discharge region.

In the embodiments, the plasma generating apparatus may further include a first feeding point on one end of the first electrode, a second feeding point on its opposite end, and a third feeding point on its middle; wherein two electromagnetic waves with a phase difference of 180° are respectively launched into the first and second feeding points to form a first standing wave in the discharge region; and the second electrode is electrically grounded and another electromagnetic wave is launched into the third feeding point to form a second standing wave in the discharge region.

In the embodiments, the first standing wave may have an amplitude similar to that of the second standing wave, and the first and second standing waves are temporarily out of phase by a range between 70° and 110° and spatially out of phase by a range between -70° and -110°, or the first and second standing waves are temporarily out of phase by a range between -70° and -110°and spatially out of phase by a range between 70° and 110°.

In the embodiments, the first and second standing waves may have the same amplitude, and they are either temporarily out of phase by 90° and spatially out of phase by -90°, or temporarily out of phase by -90° and spatially out of phase by 90°.

In the embodiments, all the input electromagnetic waves launched into at least one of the first and second electrodes have a frequency in the HF, VHF, or UHF bands.

In the embodiments, the reaction chamber may be electrically grounded.

In the embodiments, each of the first and second electrodes may be shaped in a rectangle and the discharge region may have a thickness between the first and second electrodes ranging from 0.1 to 10 cm.

In the embodiments, the rectangle may have a length ranging from 10 to 300 cm and a width ranging from 1 to 60 cm.

Further scope of applicability of the present application will become more apparent from the detailed description given hereinafter. However, it should be understood that the detailed description and specific examples, while indicating exemplary embodiments of the disclosure, are given by way of illustration only, since various changes and modifications within the spirit and scope of the disclosure will become apparent to those skilled in the art from this detailed description.

## BRIEF DESCRIPTION OF THE DRAWINGS

The present disclosure will become more fully understood from the detailed description given herein below and the accompanying drawings which are given by way of illustration only, and thus are not limitative of the present disclosure and wherein:

FIG. 1A shows perspective diagram of a plasma generating apparatus according to an embodiment of the present disclosure, and FIG. 1B is its cross-sectional view along the X direction.

FIG. 2A shows perspective diagram of a plasma generating apparatus according to a first exemplary embodiment of the present disclosure, and FIG. 2B is its cross-sectional view along the X direction.

FIG. 3A shows perspective diagram of a plasma generating apparatus according to a second exemplary embodiment of the present disclosure, and FIG. 3B is its cross-sectional view along the X direction.

FIG. 4A shows the electric field distributions in the discharge region along the centerline of the longer dimension obtained with the first standing wave at different phase angles as marked on the curves.

FIG. 4B shows the electric field distributions in the discharge region along the centerline of the longer dimension obtained with the second standing wave at different phase angles as marked on the curves.

FIG. 4C shows the electric field distributions in the discharge region along the centerline of the longer dimension at different phase angles as marked on the curves, when a traveling wave is formed by the superposition of the first and second standing waves.

## DESCRIPTION OF THE EXEMPLARY EMBODIMENTS

For further understanding and recognizing the fulfilled functions and structural characteristics of the disclosure, several exemplary embodiments cooperating with detailed description are presented as the following. Reference will now be made in detail to the preferred embodiments, examples of which are illustrated in the accompanying drawings.

In the following description of the embodiments, it is to be understood that when an element such as a layer (film), region, pattern, or structure is stated as being "on" or "under" another element, it can be "directly" on or under another element or can be "indirectly" formed such that an intervening element is also present. Also, the terms such as "on" or "under" should be understood on the basis of the drawings, and they may be used herein to represent the relationship of one element to another element as illustrated in the figures. It will be understood that this expression is intended to encompass different orientations of the elements in addition to the orientation depicted in the figures, namely, to encompass both "on" and "under". In addition, although the terms "first", "second" and "third" are used to describe various elements, these elements should not be limited by the term. Also, unless otherwise defined, all terms are intended to have the same meaning as commonly understood by one of ordinary skill in the art.

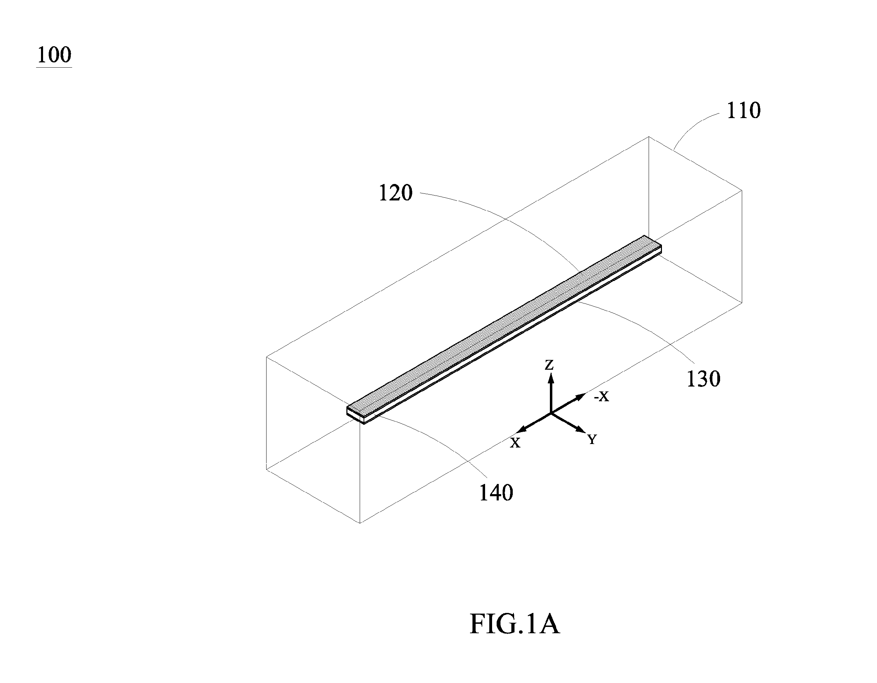

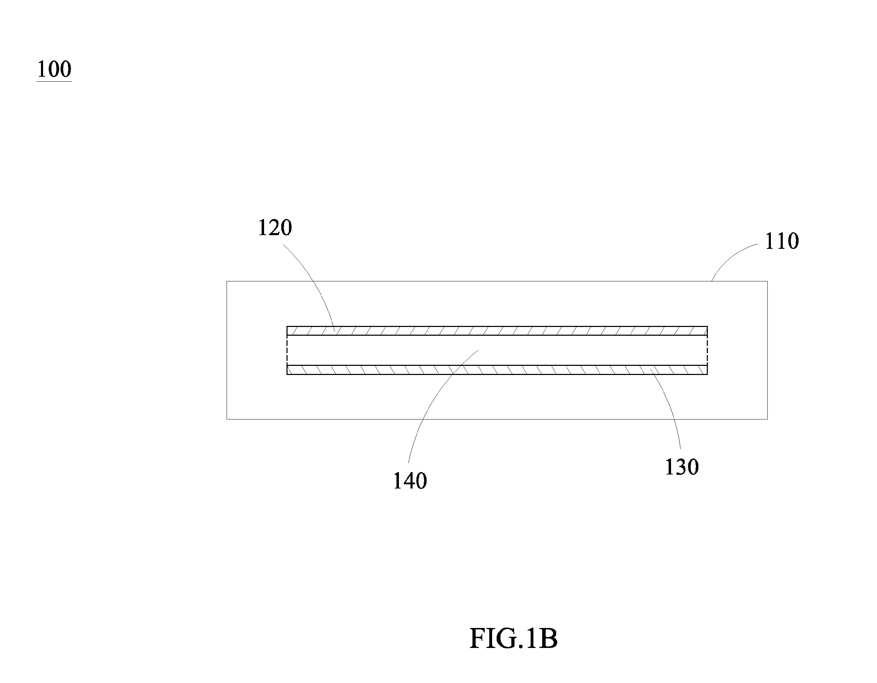

FIG. 1A shows perspective diagram of a plasma generating apparatus 100 according to an embodiment of the present disclosure, and FIG. 1B is its cross-sectional view along the X direction. The plasma generating apparatus 100 includes a reaction chamber 110, a first electrode 120, a second electrode 130, and a discharge region 140 which is a space defined by the first electrode 120 and the second electrode 130. The reaction chamber 110 may be made of metal or metal alloy, as the one used in the CCP (capacitively coupled plasma) reactors. As shown in FIGs. 1A and 1B, the first electrode 120 and the second electrode 130 are parallel to each other in the reaction chamber 110, so that plasma can be formed in the discharge region 140. The first electrode 120 and the second electrode 130 may have feeding points to be fed with electromagnetic waves, so that a travelling wave or a traveling-wave-like electromagnetic field can be generated between the electrodes 120 and 130 and travels from one end of the discharge region 140 to its opposite end, so as to uniform the plasma in the discharge region 140.

The first electrode 120 and the second electrode 130 are disposed closely to each other in the reaction chamber 110 to form the plasma in the discharge region 140. The gap between the first and second electrodes 120 and 130 may range from 0.1 to 10 cm, to define the discharge region's 140 thickness properly. In an exemplary embodiment, the discharge region 140 may have a thickness of about 2 cm. Moreover, the first electrode 120 and the second electrode 130 may have a shape of the same size. As shown in FIG. 1A, each of the electrodes 120 and 130 may be shaped in a rectangle with its length ranging from 10 to 300 cm and its width ranging from 1 to 60 cm, according to the discharge region's 140 size and shape that the electrodes 120 and 130 are to be formed. For example, each of the first electrode 120 and the second electrode 130 can be a rectangle with a length of 150 cm and a width of 10cm in the current embodiment. It should be understood that this disclosure is not limited thereto; the electrodes 120 and 130 may be shaped in a square or other suitable shape, according the design of the discharge region 140 to be formed.

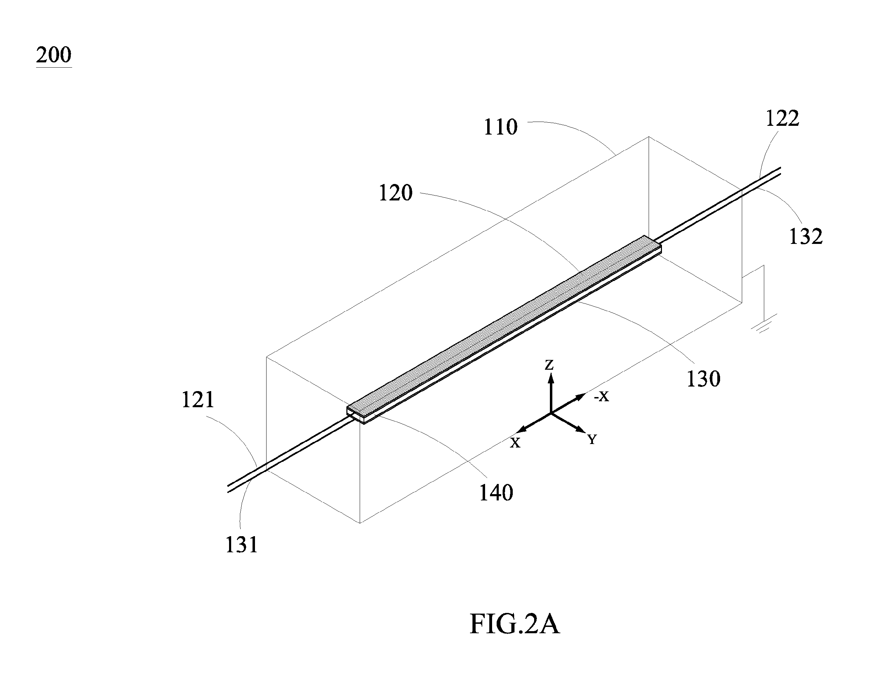

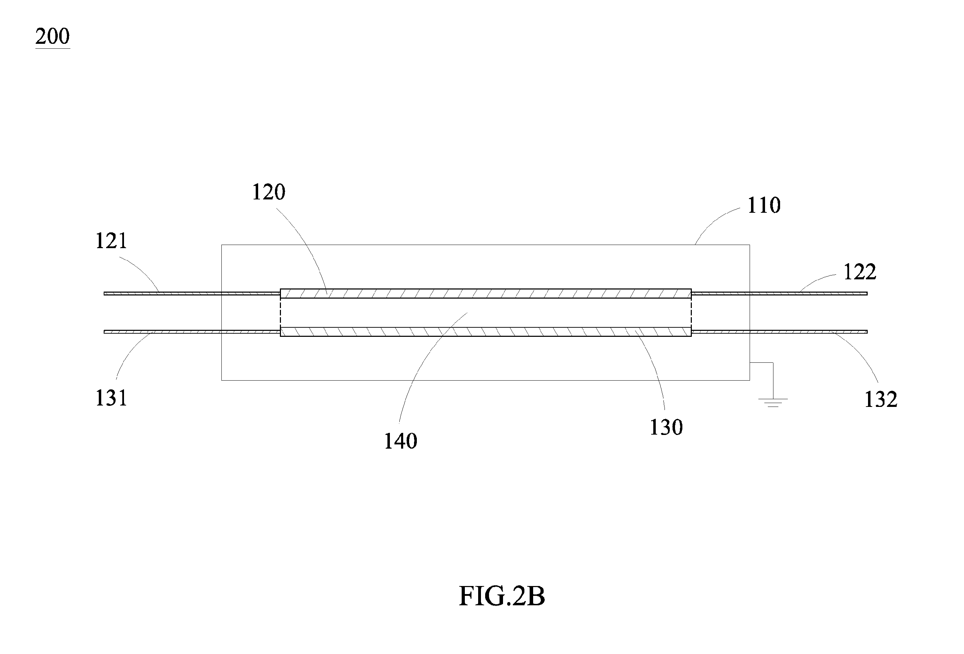

In order to generate large-area uniform plasma in the discharge region 140, a travelling wave or a traveling-wave-like electromagnetic field can be generated in the discharge region 140 by simultaneously launching multiple standing waves in this disclosure. FIG. 2A shows perspective diagram of a plasma generating apparatus 200 according to a first exemplary embodiment of the present disclosure, and FIG. 2B is its cross-sectional view along the X direction. In this exemplary embodiment, the first electrode 120 may have a first feeding point 121 on the left-hand end of the first electrode 120 and a second feeding point 122 on its right-hand end, and the second electrode 130 may have a third feeding point 131 on the left-hand end of the second electrode 130 and a fourth feeding point 132 on its right-hand end. Wherein, two electromagnetic waves with a first phase difference are respectively fed into the first and second feeding points 121 and 122, so that a first standing wave can be formed in the discharge region 140; and another two electromagnetic waves with a second phase difference which is different from the first phase difference by 180° are respectively fed into the third and fourth feeding points 131 and 132, so as to a second standing wave can be formed in the discharge region 140. In other words, the two electromagnetic waves respectively fed into the first and second feeding points 121 and 122 may be of the same amplitude and frequency, but they may have a phase difference $\psi_1$ from each other. Also, the two electromagnetic waves respectively fed into the third and fourth feeding points 131 and 132 may be of the same amplitude and frequency, but they may have a phase difference $\psi_2$ from each other, and the difference between the phase differences $\psi_1$ and $\psi_2$ is 180°. For example, if the phase difference $\psi_1$ is 180°, the phase difference $\psi_2$ can be 0°; or if the phase difference $\psi_1$ is 200°, the phase difference $\psi_2$ can be 20°.

In the embodiments, the reaction chamber may be electrically grounded. For the sake of simplicity, the above-mentioned electromagnetic waves are considered to be of sinusoidal waveform propagating in the rectangular coordinate. Thus, the first and second standing waves can be expressed by sinusoidal functions as the following mathematical formulas:

$$SW1 = A \times \cos(\omega t) \times \cos(-kx)$$

and

$$SW2 = A \times \cos(\omega t \pm 90°) \times \cos(-kx \mp 90°).$$

Wherein the first and second standing waves are denoted as SW1 and SW2, respectively, *A* denotes the amplitude of the first and second standing waves SW1 and SW2, *w* denotes the angular frequency, *t* denotes the time, *k* denotes the phase constant of the electromagnetic waves, and *x* denotes the distance along the direction of wave propagation.

If the first and second standing waves are applied to the discharge region 140 concurrently, their superposition may result in $A \times \cos(\omega t - kx)$ or $A \times \cos(\omega t + kx)$, both of which are traveling waves. As a consequence, a traveling wave can be generated in the discharge region 140, by means of superposing two standing waves that have the same amplitude and are either temporarily out of phase by 90° and spatially out of phase by -90°, or temporarily out of phase by -90° and spatially out of phase by 90°. In the embodiments, all the electromagnetic waves fed into the feeding points 121, 122, 131 and 132 may have a frequency in the high frequency (denoted as HF, radio frequency from 3 MHz to 30 MHz), very high frequency (denoted as VHF, radio frequency from 30 MHz to 300 MHz), or ultra high frequency (denoted as UHF, radio frequency from 300 MHz to 3000 MHz) bands. A uniform discharge can be obtained in the discharge region 140 due to the characteristics of traveling waves.

To verify the feasibility of realizing the traveling wave, the electric field distribution can be calculated in the simulation domain shown in FIGs. 2A and 2B. The first electrode 120 and the second electrode 130 are parallel to each other in the reaction chamber 110. The gap between the first and second electrodes 120 and 130 is 2 cm, which is also the thickness of the discharge region 140 defined by the first and second electrodes 120 and 130. Each of the electrodes 120 and 130 is shaped in a bar-like rectangle with a length of 150 cm and a width of 10cm. Such an electrode pattern is employed to avoid a significant standing wave effect along the much shorter dimension.

Two electromagnetic waves of the same amplitude and frequency with a phase difference $\psi_1 = 0°$ are fed into the first and second feeding points 121 and 122, respectively, to form the first standing wave. The frequency is 100 MHz in the current example. The wavelength of the electromagnetic wave in the discharge region is assumed to be 1.6 m.

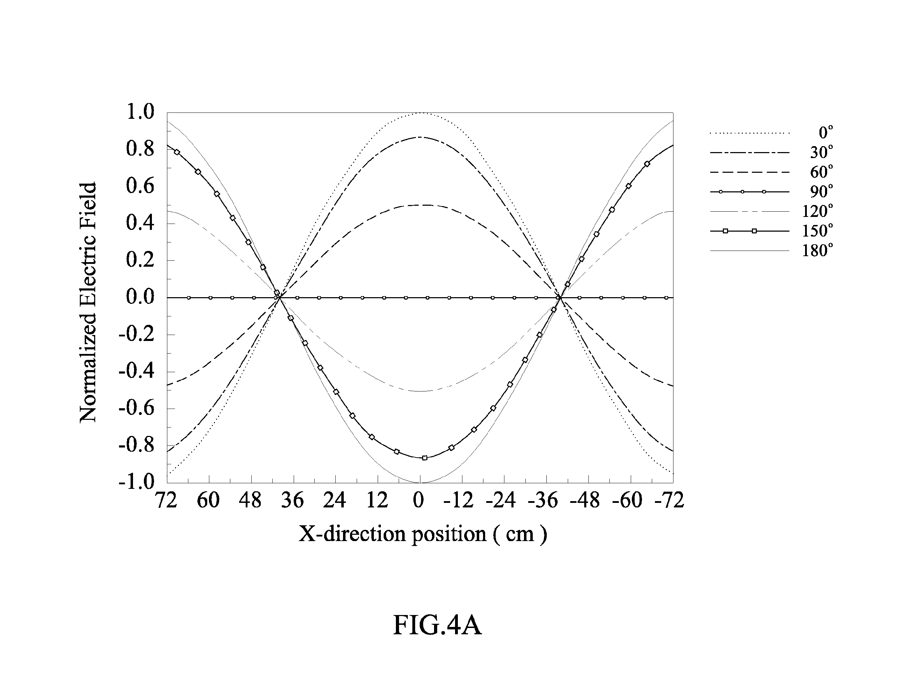

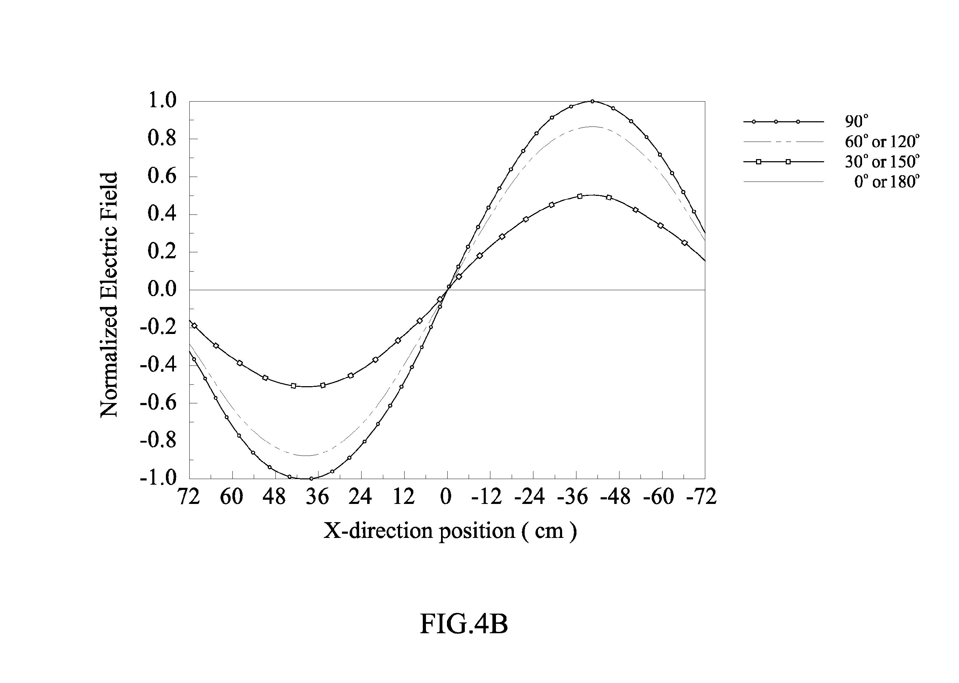

FIG. 4A shows the electric field distributions in the discharge region along the centerline of the longer dimension obtained with the first standing wave at different phase angles as marked on the curves. There is an antinode at the center for the standing wave as shown in FIG. 4A. The standing wave pattern may shift leftwards if the phase difference $\psi_1 > 0°$ and rightwards if the phase difference $\psi_1 < 0°$. Here $\psi_1 > 0°$ means that the phase angle at the feeding point 122 is leading with respect to the feeding point 121, while $\phi < 0°$ means that the phase angle at the feeding point 122 is lagging with respect to the feeding point 121. Also, another two electromagnetic waves of the same amplitude and frequency with a phase difference $\psi_2 = 180°$ are fed into the third and fourth feeding points 131 and 132, respectively. , to form the second standing wave. FIG. 4B shows the electric field distributions in the discharge region along the centerline of the longer dimension obtained with the second standing wave at different phase angles as marked on the curves. There is a node at the center for the standing wave as shown in FIG. 4B. According to FIGs. 4A and 4B, it can be observed that these two standing waves are 90° out of phase in space and time. That is, either an antinode or a node is located at the center of each electrode 120/130. Moreover, if the electric field of one of the standing waves reaches its absolute maximum, the other would be flat along the X direction.

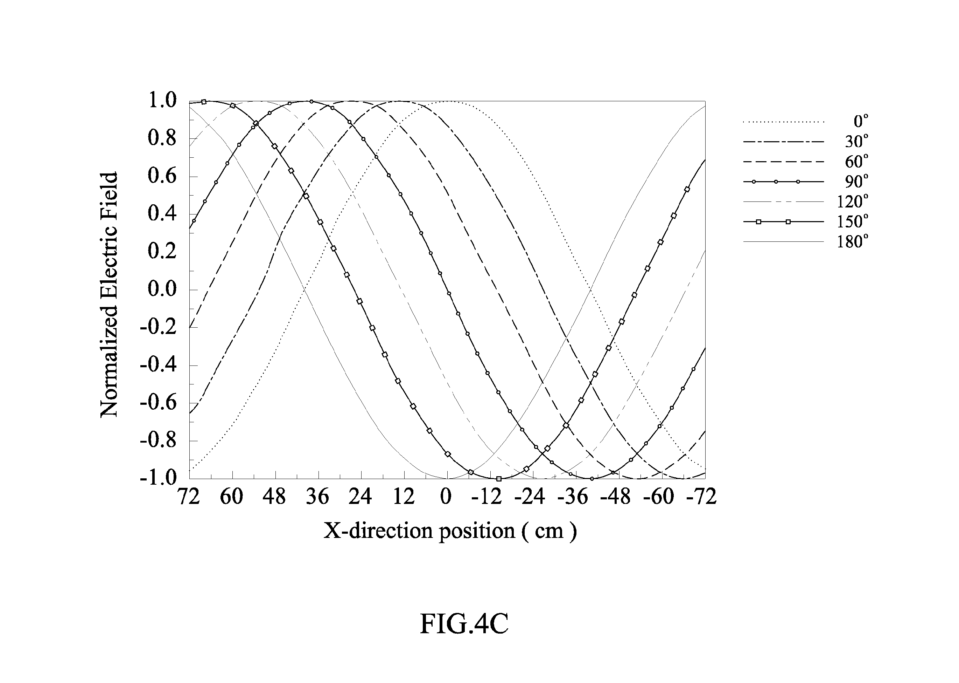

When the first standing wave, as shown in FIG. 4A, and the second standing wave, as shown in FIG. 4B, are applied simultaneously to the discharge region 140 between the first and second electrodes 120 and 130, the resulting electric field distribution can be plotted in FIG. 4C. The main features in FIG. 4C are that the electric field's absolute maximums may shift its positions as the time passes and that the absolute maximums do not change with time. These features indicate that the superposition of the two standing waves can form a pure traveling wave, which may propagate in the discharge region 140 from one end to the other. Once the traveling wave is produced in the plasma, all the locations would experience a complete wave cycle during its propagation. As a result, a uniform plasma discharge can be expected in the discharge region 140.

In the above-described exemplary embodiment, to form a pure traveling wave, the input voltage and the initial phase angle for each feeding point must be carefully adjusted to ensure that both standing waves have the same amplitude and they are either temporarily out of phase by 90° and spatially out of phase by -90°, or temporarily out of phase by -90° and spatially out of phase by 90°. In some cases, however, it is not easy to generate a pure traveling wave in the discharge region 140, or it may be effective enough to have an electromagnetic pattern close to a pure travelling wave to uniform the plasma in the discharge region 140, to a certain extent. For example, if the standing waves have slightly different amplitudes, their superposition would be dominated by the standing wave with larger amplitude. That is, the locations with absolute maximum electric field (or electric voltage) are determined by the larger standing wave. However, due to the slight difference in the amplitudes of the two standing waves, the superposition will still be quite similar to a pure traveling wave, i.e., a traveling-wave-like electromagnetic field or an electromagnetic field with a traveling-wave base. For some applications, such as thin film silicon solar cell, the requirement for the non-uniformity of thin film deposition is below 10%. A traveling-wave-like electromagnetic wave may be sufficient to fulfill the requirement. Furthermore, we may fail to meet the requirement for temporary and spatial phase differences of 90° or we do not need a pure traveling wave in the discharge region 140 for some considerations. For such cases, the first standing wave may have an amplitude similar to that of the second standing wave, and the first and second standing waves are temporarily out of phase by a range between 70° and 110° and spatially out of phase by a range between -70° and -110°, or they are temporarily out of phase by a range between -70° and -110° and spatially out of phase by a range between 70° and 110°. Thus, a major part of the first and second standing waves are converted into a traveling wave in the discharge region 140, and the remainder part are still standing waves in the discharge region 140. The combination of the traveling wave and the standing waves can be used to uniform, to a certain extent, the plasma in the discharge region 140.

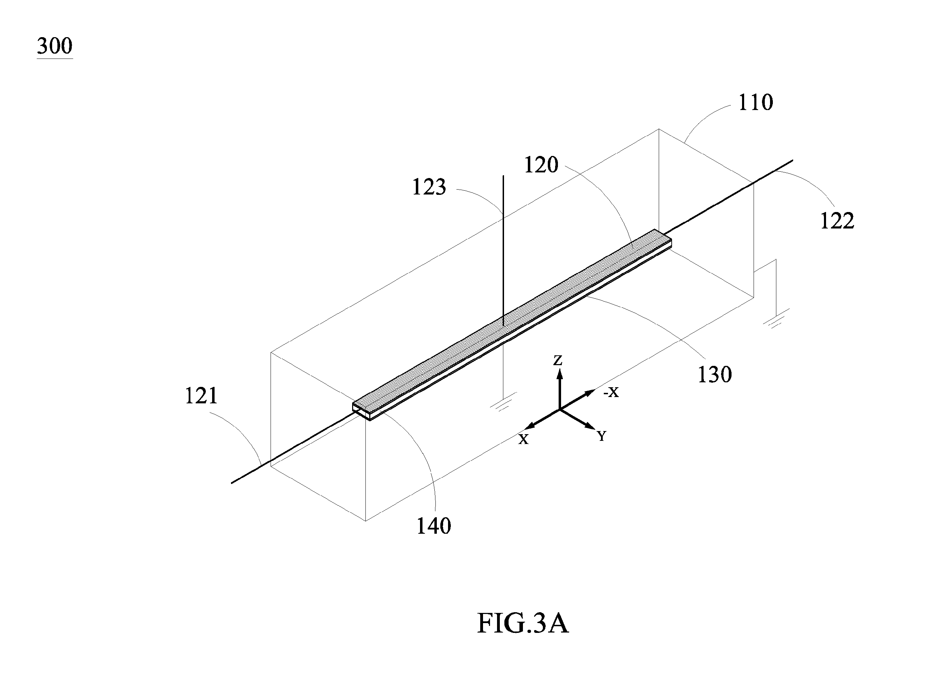

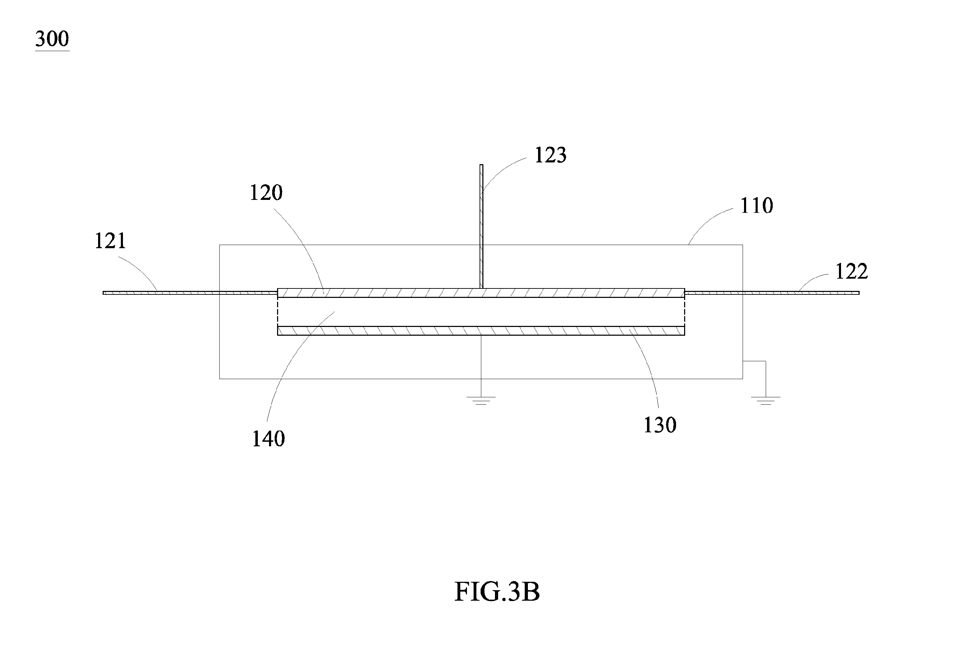

FIG. 3A shows perspective diagram of a plasma generating apparatus 300 according to a second exemplary embodiment of the present disclosure, and FIG. 3B is its cross-sectional view along the X direction. In this exemplary embodiment, the second electrode 130 is electrically grounded while the first electrode 120 has a first feeding point 121 on the left-hand end of the first electrode 120, a second feeding point 122 on its right-hand end, and a third feeding point 123 at its middle. Wherein, two electromagnetic waves with a phase difference of 180° are respectively fed into the first and second feeding points 121 and 122, so that a first standing wave can be formed in the discharge region 140. Also, another electromagnetic wave is fed into the third feeding point 123 to form a second standing wave in the discharge region 140. In some embodiments, the first standing wave may have an amplitude similar to that of the second standing wave, and the first and second standing waves are temporarily out of phase by a range between 70° and 110° and spatially out of phase by a range between -70° and -110°, or they are temporarily out of phase by a range between -70° and -110° and spatially out of phase by a range between 70° and 110°. Thus, a major part of the first and second standing waves are converted into a traveling wave in the discharge region 140, and the remainder part are still standing waves in the discharge region 140. The combination of the traveling wave and the standing waves can be used to uniform, to a certain extent, the plasma in the discharge region 140. For example, if the standing waves have slightly different amplitudes, their superposition would be dominated by the standing wave with larger amplitude. That is, the locations with maximum electric field (or electric voltage) are determined by the larger standing wave. However, due to the slight difference in the amplitudes of the two standing waves, the superposition will still be quite similar to a pure traveling wave, i.e., a traveling-wave-like electromagnetic field or an electromagnetic field with a traveling-wave base.

In a preferable embodiment, the first and second standing waves may have the same amplitude and are temporarily and spatially out of phase by 90°, which are superposed to form a traveling wave in the discharge region 140. The temporary and spatial phase differences have different signs. Once the traveling wave is produced in the plasma region, all the locations therein would experience a complete wave cycle during its propagation, as the traveling wave scans the discharge region 140 from one end to the other. Hence, a uniform plasma discharge can be expected in the discharge region 140. In the embodiments, all the input electromagnetic waves launched into at least one of the first and second electrodes may have a frequency in the HF, VHF, or UHF bands.

As described in the above disclosure, a plasma generating apparatus has been presented to generate uniform plasma with large area electrodes. Compared to most of the existing techniques, the current apparatus is more advantageous because of the following reasons. First, it has the potentials to be applicable to various frequencies and a wider operation window because it is not designed to match up with a specific standing wave pattern. Even if the actual wavelength in plasma depends on varieties of parameters, the variation in wavelength would only lead to change in the number of wave cycles appearing on the electrodes at a given moment. However, the characteristics of traveling wave could still produce uniform discharge as long as the effect of wave decay is not significant. Secondly, the typical requirement of deposition non-uniformity for thin film silicon solar cell is < 10%, which is determined by the ratio of the difference between maximum and minimum thickness to the summation of maximum and minimum values. If the thin film deposition rate is linearly proportional to electric field (or voltage), it suggests that the requirement can still be fulfilled even if the traveling wave decays by around 20%. In other words, the current apparatus in this disclosure possesses a tolerance for slight wave attenuation.

With respect to the above description then, it is to be realized that the optimum dimensional relationships for the parts of the disclosure, to include variations in size, materials, shape, form, function and manner of operation, assembly and use, are deemed readily apparent and obvious to one skilled in the art, and all equivalent relationships to those illustrated in the drawings and described in the specification are intended to be encompassed by the present disclosure.

**Claims**

1.  A plasma generating apparatus comprising:

    a reaction chamber;
    a first electrode disposed in the reaction chamber;
    a second electrode parallel with the first electrode and disposed in the reaction
    chamber; and
    a discharge region formed between the first and second electrodes and a plasma
    can be formed therein;
    wherein a travelling wave or a traveling-wave-like electromagnetic field is
    generated via at least one of the first and second electrodes and travels from one end of the discharge region
    to its opposite end.

2.  The plasma generating apparatus according to claim 1, further comprising a first feeding point on one end of the first electrode and a second feeding point on
    its opposite end; and
    a third feeding point on one end of the second electrode and a fourth feeding point
    on its opposite end;
    wherein two electromagnetic waves with a first phase difference are respectively
    launched into the first and second feeding points, so as to form a first standing wave in the discharge region; and
    wherein two electromagnetic waves with a second phase difference are
    respectively launched into the third and fourth feeding points, so as to form a second standing wave in the discharge region.

3.  The plasma generating apparatus according to claim 2, wherein the first standing wave has an amplitude similar to that of the second standing wave, and the first and second standing waves are temporarily out of phase by a range between 70° and 110° and spatially out of phase by a range between -70° and -110°, or the first and second standing waves are temporarily out of phase by a range between -70° and - 110° and spatially out of phase by a range between 70° and 110°.

4. The plasma generating apparatus according to claim 2, wherein the first and second standing waves have the same amplitude, and are either temporarily out of phase by 90° and spatially out of phase by -90°, or temporarily out of phase by -90° and spatially out of phase by 90°.

5. The plasma generating apparatus according to claim 2, wherein each of the electromagnetic waves has a frequency in the HF, VHF, or UHF bands.

6. The plasma generating apparatus according to claim 1, further comprising a first feeding point on one end of the first electrode, a second feeding point on its
opposite end, and a third feeding point on its middle;
wherein two electromagnetic waves with a phase difference of 180 ° are
respectively launched into the first and second feeding points to form a first standing wave in the discharge region; and
wherein the second electrode is electrically grounded and another electromagnetic
wave is launched into the third feeding point to form a second standing wave in the discharge region.

7. The plasma generating apparatus according to claim 6, wherein the first standing wave has an amplitude similar to that of the second standing wave, and the first and second standing waves are temporarily out of phase by a range between 70° and 110° and spatially out of phase by a range between -70° and -110°, or the first and second standing waves are temporarily out of phase by a range between -70° and - 110° and spatially out of phase by a range between 70° and 110°.

8. The plasma generating apparatus according to claim 6, wherein the first and second standing waves have the same amplitude, and are either temporarily out of phase by 90° and spatially out of phase by -90°, or temporarily out of phase by -90° and spatially out of phase by 90°.

9. The plasma generating apparatus according to claim 6, wherein each of the electromagnetic waves has a frequency in the HF, VHF, or UHF bands.

10. The plasma generating apparatus according to claim 1, wherein the reaction chamber is electrically grounded.

11. The plasma generating apparatus according to claim 1, wherein each of the first and second electrodes is shaped in a rectangle and the discharge region has a thickness between the first and second electrodes ranging from 0.1 to 10 cm.

12. The plasma generating apparatus according to claim 11, wherein the rectangle has a length ranging from 10 to 300 cm and a width ranging from 1 to 60 cm.

FIG.1A

FIG.1B

100

120

140

130

110

EP 2 816 586 A1

200

FIG.2A

200

FIG.2B

EP 2 816 586 A1

300

121

140

123

120

130

110

122

x
z
y
-x

FIG.3A

EP 2 816 586 A1

FIG.3B

300

130

140

122

110

121

120

123

FIG.4A

FIG.4B

FIG.4C

Europäisches
Patentamt

European
Patent Office

Office européen
des brevets

## EUROPEAN SEARCH REPORT

Application Number

EP 13 17 2352

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/245214 A1 (BAEK JONGHOON [US]) 30 September 2010 (2010-09-30) * figures 1,3 * * paragraph [0034] * * paragraph [0038] * * paragraph [0039] * * paragraph [0046] * * paragraph [0054] * ----- | 1 | INV. H01J37/32 |
| X | US 2011/120652 A1 (CHANG CHIA-HAO [TW] ET AL) 26 May 2011 (2011-05-26) * figure 1 * * paragraph [0023] - paragraph [0028] * ----- | 1 | |
| X | JP 2006 221887 A (MURATA MASAYOSHI) 24 August 2006 (2006-08-24) * figures 1-8 * * paragraph [0029] - paragraph [0055] * ----- | 1-5 | |
| Y | | 6-12 | |
| X | JP 2006 332704 A (MURATA MASAYOSHI) 7 December 2006 (2006-12-07) * abstract * * pages 1-7; figures 1-7 * ----- | 1-5 | TECHNICAL FIELDS SEARCHED (IPC) |
| X | EP 2 237 310 A1 (MURATA MASAYOSHI [JP]) 6 October 2010 (2010-10-06) * figures 1,3,5-7 * * paragraph [0045] - paragraph [0091] * ----- | 1-5 | H01J C23C |
| Y | EP 2 239 760 A1 (FORSCH APPLIKATIONSLABOR PLASM [DE]) 13 October 2010 (2010-10-13) * figure 1 * * paragraph [0004] * * paragraph [0012] * * paragraph [0030] - paragraph [0037] * ----- | 6-12 | |

-/--

The present search report has been drawn up for all claims

| Place of search | Date of completion of the search | Examiner |
|---|---|---|
| The Hague | 14 November 2013 | Hochstrasser, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt European Patent Office Office européen des brevets | **EUROPEAN SEARCH REPORT** | Application Number EP 13 17 2352 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STEPHAN U ET AL: "Problems of power feeding in large area PECVD of amorphous silicon", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, PITTSBURG, PA; US, vol. 557, 1 January 1999 (1999-01-01), pages 157-162, XP002594176, ISBN: 978-1-55899-828-5 * the whole document * ----- | 1-12 | |

| | | | TECHNICAL FIELDS SEARCHED (IPC) |
|---|---|---|---|

The present search report has been drawn up for all claims

| Place of search | Date of completion of the search | Examiner |
|---|---|---|
| The Hague | 14 November 2013 | Hochstrasser, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 13 17 2352

This annex lists the patent family members relating to the patent documents cited in the above-mentioned European search report.
The members are as contained in the European Patent Office EDP file on
The European Patent Office is in no way liable for these particulars which are merely given for the purpose of information.

14-11-2013

| Patent document cited in search report | Publication date | Patent family member(s) | Publication date |
|---|---|---|---|
| US 2010245214 A1 | 30-09-2010 | NONE | |
| US 2011120652 A1 | 26-05-2011 | TW 201119517 A<br>US 2011120652 A1 | 01-06-2011<br>26-05-2011 |
| JP 2006221887 A | 24-08-2006 | NONE | |
| JP 2006332704 A | 07-12-2006 | NONE | |
| EP 2237310 A1 | 06-10-2010 | CN 101897005 A<br>EP 2237310 A1<br>JP 2008047938 A<br>TW 200929338 A<br>US 2010239757 A1<br>WO 2009050958 A1 | 24-11-2010<br>06-10-2010<br>28-02-2008<br>01-07-2009<br>23-09-2010<br>23-04-2009 |
| EP 2239760 A1 | 13-10-2010 | DE 102009015178 A1<br>EP 2239760 A1 | 23-09-2010<br>13-10-2010 |

EPO FORM P0459

For more details about this annex : see Official Journal of the European Patent Office, No. 12/82